# EUROPEAN PATENT APPLICATION

(11) **EP 3 716 344 A1**
(43) Date of publication of application: **30.09.2020**
(21) Application number: 20165594.1
(22) Date of filing: 25.03.2020
(51) Int. Cl.: H01L 31/048, B32B 17/00

(54) **MANUFACTURING METHOD OF SOLAR CELL MODULE**

(30) Priority: 27.03.2019 JP 2019060793
(71) Applicant: Panasonic Corporation, Osaka 571-8501 (JP)
(72) Inventor: SOTANI, Naoya, Osaka, 571-8501 (JP); TSUMURA, Shinya, Osaka, 571-8501 (JP); YOSHIMINE, Yukihiro, Osaka, 571-8501 (JP)
(74) Representative: Müller-Boré & Partner Patentanwälte PartG mbB

(57) **Abstract**

A manufacturing step for a solar cell module (10) according to an example of an embodiment includes a lamination step of heating a multilayer structure while pressurizing the multilayer structure with a pressing member (22), the multilayer structure having a structure in which a solar cell (11), a first substrate (12), a second substrate (13), a first encapsulant (14), and a second encapsulant (15), are superimposed. In the lamination step, the pressurization by the pressing member is stopped at a temperature at which the loss modulus of the first encapsulant is maintained at 10³ Pa or more.

## Description

The present disclosure relates to a manufacturing method of a solar cell module, and more particularly, to a manufacturing method of a solar cell module including a lamination step.

A solar cell module generally includes a string of solar cells formed by connecting a plurality of solar cells with a wiring member, two substrates that nip the string, and an encapsulant that is filled in a space between the substrates to seal each of the solar cells. For example, Japanese Unexamined Patent Application Publication No. 2013-118321 A discloses a manufacturing method of a solar cell module including a lamination step of thermally compressing, from a light receiving surface of the solar cell module, a glass substrate, a resin sheet forming a first encapsulant, a string of solar cells, a resin sheet forming a second encapsulant, and a back sheet, in a superimposed manner.

Incidentally, in the lamination step described above, when each encapsulant is heated, flowability is exhibited. In this case, the second encapsulant may reach the light receiving surface of each solar cell. As the second encapsulant, a resin having a lower transparency than that of the first encapsulant may be used, or a coloring material, such as a white pigment, may be added. Accordingly, if the second encapsulant reaches the light receiving surface of each solar cell, a problem such as a deterioration in appearance of the solar cell module may occur. On the other hand, the lamination step can be carried out at a low temperature so as to prevent the second encapsulant from reaching the light receiving surface of each solar cell. In this case, for example, a satisfactory adhesion force of each of the encapsulants and the substrate cannot be obtained, so that peeling is more likely to occur at an interface between each encapsulant and the substrate.

An object of the present disclosure is to provide a manufacturing method of a solar cell module capable of fully preventing a second encapsulant from reaching a light receiving surface of a solar cell, while maintaining a satisfactory adhesion force of each encapsulant and a substrate.

A manufacturing method of a solar cell module according to an aspect of the present disclosure includes a lamination step of heating a multilayer structure while pressurizing the multilayer structure with a pressing member, the multilayer structure having a structure in which a solar cell, a first substrate that covers a light receiving surface of the solar cell, a second substrate that covers a rear surface of the solar cell, a first encapsulant filled in a space between the first substrate and the solar cell, and a second encapsulant filled in a space between the solar cell and the second substrate are superimposed. In the lamination step, the pressurization by the pressing member is stopped at a temperature at which a loss modulus of the first encapsulant is maintained at 10³ Pa or more. Alternatively, the pressurization by the pressing member is stopped at a point when a temperature of the multilayer structure reaches a temperature in a range from 80°C to 110°C.

A manufacturing method of a solar cell module according to the present disclosure can fully prevent a second encapsulant from reaching a light receiving surface of a solar cell, while maintaining a satisfactory adhesion force of each of the encapsulant and a substrate.

The drawings depict one or more implementations in accordance with the present disclosure, by way of example only, not by way of limitation. In the drawings, like reference numerals refer to the same or similar elements where:
FIG. 1 is a sectional view illustrating a solar cell module as an example of an embodiment;
FIG. 2 is a graph illustrating a change in loss modulus in association with a temperature change of an encapsulant;
FIG. 3 illustrates a lamination step as an example of the embodiment;
FIG. 4 illustrates the lamination step as an example of the embodiment;
FIG. 5 is a graph illustrating a manufacturing method of a solar cell module as an example of the embodiment; and
FIG. 6 illustrates a related-art manufacturing method.

A manufacturing method of a solar cell module according to an embodiment of the present disclosure will be described in detail below with reference to the drawings. The following embodiments are merely examples, and the manufacturing method according to the present disclosure is not limited to the embodiments. Further, the drawings to be referred to in the following embodiments are schematically illustrated. Accordingly, dimensions, ratios, and the like of constituent elements illustrated in the drawings should be determined in consideration of the following description.

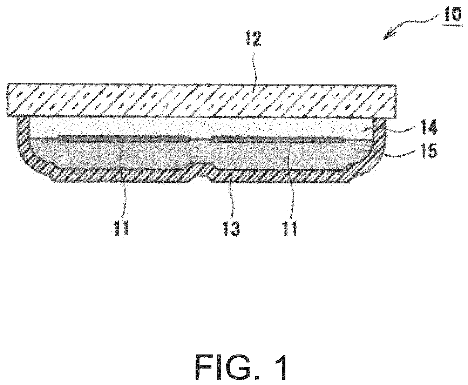

FIG. 1 is a sectional view illustrating a solar cell module 10 as an example of an embodiment. As illustrated in FIG. 1, the solar cell module 10 includes solar cells 11, a glass substrate 12 (first substrate) that covers a light receiving surface of each of the solar cells 11, and a back sheet 13 (second substrate) that covers a rear surface of each of the solar cells 11. The first substrate disposed on the light receiving surface of each of the solar cells 11 may be a resin substrate, and the second substrate disposed on the rear surface of each of the solar cells 11 may be a glass substrate. The solar cell module 10 has, for example, a rectangular shape in plan view. However, the shape of the solar cell module 10 can be changed as appropriate. The solar cell module 10 may have a square shape in plan view, a pentagonal shape in plan view, or the like.

The term "light receiving surface" of each of the solar cells 11 refers to a surface on which light is mainly incident. The term "rear surface" refers to a surface opposite to the light receiving surface. In the light incident on each of the solar cells 11, more than 50% of the light, for example, 80% or more or 90% or more of the light, is incident from the light receiving surface. The terms "light receiving surface" and "rear surface" are also used for the solar cell module 10, a photoelectric conversion part, which is described below, and the like.

The solar cell module 10 includes a first encapsulant 14 that is filled in a space between the solar cells 11 and the glass substrate 12, and a second encapsulant 15 that is filled in a space between the solar cells 11 and the back sheet 13. The solar cells 11 are nipped between the glass substrate 12 and the back sheet 13 and are sealed by the first encapsulant 14 and the second encapsulant 15. In an example illustrated in FIG. 1, two solar cells 11 are illustrated. However, the number of solar cells 11 included in the solar cell module 10 is not particularly limited. The solar cell module 10 generally includes a plurality of solar cells 11. Adjacent solar cells 11 are connected in series with a wiring member, which is not illustrated, thereby forming a string of the solar cells 11.

Each solar cell 11 includes a photoelectric conversion part that generates carriers by receiving sunlight, and a collector electrode that is provided on the photoelectric conversion part and collects carriers. The photoelectric conversion part has, for example, a substantially square shape in plan view, the four corners of which are obliquely cut. Examples of the photoelectric conversion part include a semiconductor substrate made of crystalline silicon (Si), gallium arsenide (GaAs), indium phosphide (InP), an amorphous semiconductor layer formed on the semiconductor substrate, and a transparent conductive layer formed on the amorphous semiconductor layer.

The collector electrode is composed of, for example, a light receiving surface electrode formed on the light receiving surface of the photoelectric conversion part, and a rear surface electrode formed on the rear surface of the photoelectric conversion part. The collector electrode preferably includes a plurality of finger electrodes. The plurality of finger electrodes are narrow line-shaped electrodes formed substantially parallel. The collector electrode may include a bus bar electrode that has a wider width than each finger electrode and is substantially orthogonal to each finger electrode. The rear surface electrode may be an electrode that covers substantially the entire area of the rear surface of the photoelectric conversion part.

The glass substrate 12 covers the entirety of the string of the solar cells 11 and protects the solar cells 11 from an external impact, moisture, and the like. The glass substrate 12 preferably has a high total light transmittance. For example, the total light transmittance is 80% to 100%, or 85% to 95%. The total light transmittance is measured base on JIS K7361-1 (Total Light Transmittance Test Method for Plastics and Transparent Material Part I: Single Beam Method).

As the back sheet 13, a transparent substrate may be used, like the glass substrate 12. Alternatively, an opaque substrate may be used. The total light transmittance of the back sheet 13 is not particularly limited, and may be 0%. As the back sheet 13, a resin sheet having a thickness smaller than that of the glass substrate 12 is used, for example, from the viewpoint of weight saving of the solar cell module.

Each of the first encapsulant 14 and the second encapsulant 15 includes a resin that exhibits flowability in a lamination step, which is described below, as a major component. Further, each of the first encapsulant 14 and the second encapsulant 15 may include an antioxidant or an ultraviolet absorbing agent. The first encapsulant 14 is formed of a colorless transparent resin having a high total light transmittance. On the other hand, the second encapsulant 15 may include a coloring material such as a white pigment. A white pigment, such as a titanium oxide, has a function for reflecting sunlight and increasing light incident on the solar cells 11. From the viewpoint of design and the like of the solar cell module 10, the second encapsulant 15 may include a black-based coloring material having a color similar to that of the solar cells 11.

As the resin forming the first encapsulant 14, a polyolefin (e.g., polyethylene, polypropylene, or a random or block copolymer of ethylene and α olefin) obtained by polymerizing at least one type selected from ethylene and α-olefins with carbon numbers 3 to 20, polyester, polyurethane, epoxy resin, and a copolymer (e.g., ethylene-vinyl acetate copolymer) of ethylene with vinyl carboxylate, acrylic ester, or other vinyl monomers, may be used.

The first encapsulant 14 preferably includes a thermosetting resin. A thermosetting resin is a cross-linkable resin containing a crosslinking component, a crosslinking agent, or the like in which a crosslinking reaction advances by heating. A cross-linkable polyolefin (hereinafter referred to as "POE") is particularly preferably used as a resin forming the first encapsulant 14. When POE is used as the first encapsulant 14, a satisfactory sealing property can be obtained and the reliability of the solar cell module 10 is enhanced.

The cross-linking start temperature of the first encapsulant 14 is, for example, 135°C to 140°C, or a temperature higher than 140°C. The cross-linking start temperature is a temperature at which crosslinking advances at a certain extent for a period required for the lamination step, i.e., about 60 seconds to 600 seconds. In the present embodiment, the cross-linking start temperature is a temperature at which a loss tangent (tanδ = G2/G1, G1: storage modulus, G2: loss modulus) measured by cure torque (JIS K6300-2) becomes lower than "1" in about 10 minutes.

The second encapsulant 15 may be formed of the same resin as that of the first encapsulant 14, and is preferably formed of a resin different from that of the first encapsulant 14. Further, the second encapsulant 15 preferably includes a thermosetting resin. A cross-linkable ethylene-vinyl acetate copolymer (hereinafter referred to as "EVA") is particularly preferably used as a resin forming the second encapsulant 15. EVA includes, as a crosslinking agent, an organic peroxide such as benzoyl peroxide, dicumyl peroxide or 2, 5-dimethyl-2, 5-di(t-butylperoxy)hexane.

The cross-linking start temperature of the second encapsulant 15 may be lower than the cross-linking start temperature of the first encapsulant 14. The cross-linking start temperature of the second encapsulant 15 is, for example, 120°C to 130°C. The viscosity of each encapsulant during heating and fusing in the lamination step is not particularly limited. However, in the case of using the above-described materials for each encapsulant, the viscosity of the second encapsulant 15 before starting hardening is higher than the viscosity of the first encapsulant 14 before starting hardening. Therefore, the flowability of each encapsulant in the lamination step satisfies "first encapsulant 14 > second encapsulant 15".

A change in the loss modulus G2 in association with a temperature change of each encapsulant shows a tendency similar to that of a change in the viscosity of each encapsulant. In an elastic body having a viscosity, a complex elastic modulus G* (G* = G1 + iG2, i² = -1) is used as a value for an elastic modulus E. The loss modulus G2 indicates a scale of energy lost due to heat generation or the like during deformation, and is an index indicating a viscosity. In the present embodiment, the loss modulus G2 of each encapsulant is obtained by a dynamic viscoelasticity (see DMA, Literature "Network Polymer" Vol. 32, No. 6 (2011), p. 362).

Measurement conditions for DMA are as follows.
Frequency: 10 Hz
Rate of temperature increase: 10°C/min (-50°C to 150°C)
Deformation mode: pulling

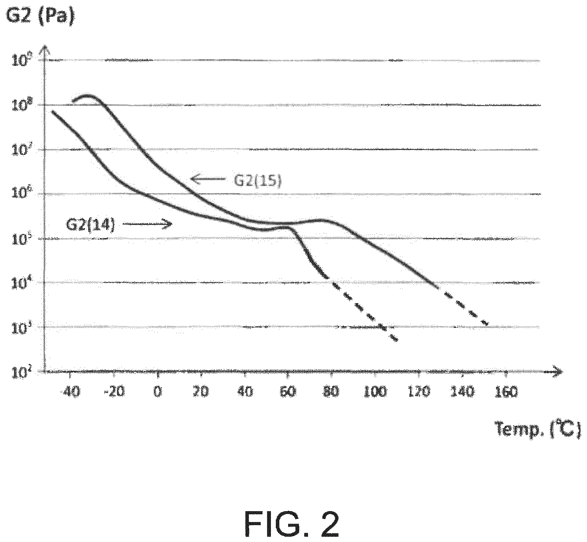

FIG. 2 illustrates an example of the dependence of each of the loss modulus G2 (14) of the first encapsulant 14 and the loss modulus G2 (15) of the second encapsulant 15, which are obtained under the above-described conditions, on the temperature. In this case, the first encapsulant 14 is POE, and the second encapsulant 15 is EVA including a white pigment. As illustrated in FIG. 2, the loss modulus G2 (viscosity) of the first encapsulant 14 is lower than that of the second encapsulant 15. Further, the loss modulus G2 of any encapsulant exponentially decreases as the temperature rises. As described in detail below, in order to prevent the second encapsulant 15 from reaching the light receiving surface of each solar cell 11, a highest achieved temperature of the multilayer structure 16 is more important than a pressurization time required for a pressing member 22.

Each of the first encapsulant 14 and the second encapsulant 15 preferably contains a coupling agent. The use of the coupling agent makes it possible to improve an adhesion force between each encapsulant and the solar cells 11, the glass substrate 12, and the back sheet 13, so that interfacial peeling can be easily prevented. Examples of the coupling agent include a silane coupling agent, a titanate-based coupling agent, and an aluminate-based coupling agent. Among these agents, a silane coupling agent is particularly preferably used. Examples of the silane coupling agent include vinyl triethoxysilane, γ-glycidoxypropyltrimethoxysilane, and γ-methacryloxypropyltrimethoxysilane.

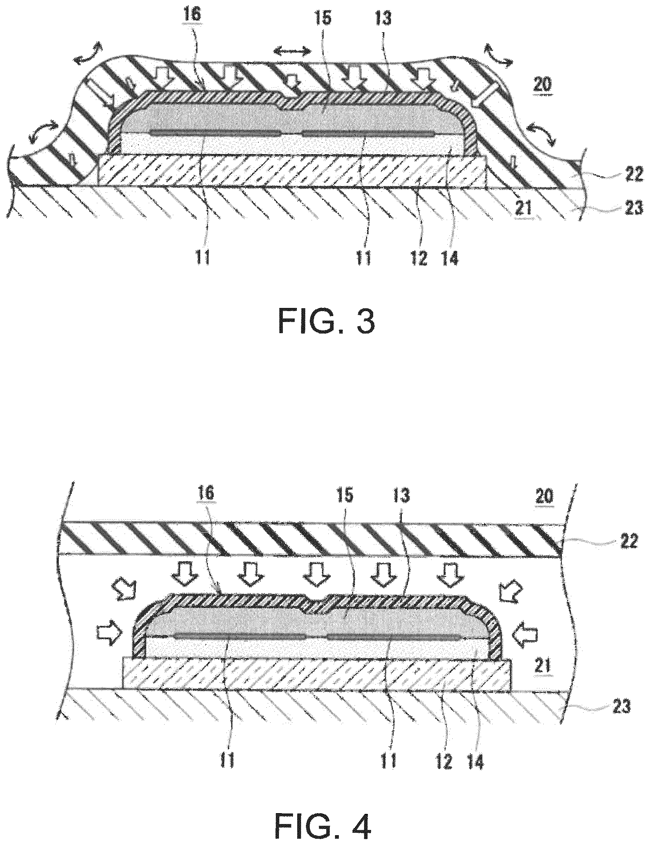

An example of the manufacturing method of the solar cell module 10 will be described in detail below with reference to FIGS. 3 to 6. FIGS. 3 and 4 each illustrate the lamination step for the solar cell module 10.

The solar cell module 10 is manufactured through the lamination step illustrated in FIGS. 3 and 4. The lamination step is a step of heating the multilayer structure 16, which has a structure in which the solar cells 11, the glass substrate 12, the back sheet 13, the first encapsulant 14, and the second encapsulant 15 are superimposed, while pressurizing the multilayer structure 16 with the pressing member 22, and thermally compressing each member. The manufacturing step of the solar cell module 10 may further include a curing step of performing a heat treatment on the multilayer structure 16 thermally compressed in the lamination step. In the curing step, a crosslinking reaction of each encapsulant and a reaction of a silane coupling agent are preferably advanced by performing a heat treatment on the multilayer structure 16 at a higher temperature than in the lamination step.

As illustrated in FIGS. 3 and 4, the lamination step is performed using a lamination apparatus including an upper chamber 20 and a lower chamber 21. Each of the upper chamber 20 and the lower chamber 21 is a vacuum chamber which is connected to a vacuum pump, which is not illustrated, and can be evacuated, and is partitioned by the pressing member 22 for pressurizing the components of the solar cell module 10. As the pressing member 22, a heat-resistant rubber-like member, such as flexible silicone rubber, is generally used. In the lower chamber 21, a heater 23 having a flat surface on which the components of the solar cell module 10 can be placed is installed.

In the lamination step, the components of the solar cell module 10 are disposed on the heater 23 and are thermally compressed with each other. Specifically, the multilayer structure 16 is formed by superimposing the glass substrate 12, the first encapsulant 14, the string of the solar cells 11, the second encapsulant 15, and the back sheet 13 in an order from the side closest to the heater 23. In the present embodiment, all steps carried out in the lamination apparatus are defined as the lamination step.

The first encapsulant 14 and the second encapsulant 15 are generally supplied in the form of a resin sheet. The thickness of the resin sheet is, for example, 0.1 mm to 1 mm. The first encapsulant 14 and the second encapsulant 15 are heated through the glass substrate 12 in contact with the heater 23.

As illustrated in FIG. 3, in the lamination step, the multilayer structure 16 is heated by being pressurized by the pressing member 22. In the present embodiment, first, the multilayer structure 16 is heated for a predetermined time, while the upper chamber 20 and the lower chamber 21 are evacuated. In this case, gaseous components, such as air, are removed from gaps or voids present in the multilayer structure 16. Next, air exhaustion in the upper chamber 20 is stopped and the atmosphere is introduced into the upper chamber 20. Since the lower chamber 21 is evacuated, the upper chamber 20 is pressurized to thereby allow the flexible pressing member 22 to extend toward the heater 23 and press the multilayer structure 16 from above. The pressure during the pressurization is, for example, 0.5 atmospheric pressure to atmospheric pressure (1 atm). Alternatively, the upper chamber 20 may be pressurized at 1 atmospheric pressure or more.

The multilayer structure 16 is compressed by the pressing member 22 from the back sheet 13 in a state where the multilayer structure 16 is disposed on the heater 23. As described in detail below, in the lamination step, the pressurization by the pressing member 22 is stopped at a temperature at which a loss modulus of the first encapsulant 14 is maintained at 10³ Pa or more. After that, in the lamination apparatus, the heating is continued for a predetermined time under atmospheric pressure and then the heating is performed until the cross-linking start temperature or higher of each encapsulant is reached (see FIG. 4). In this case, the pressure in the lower chamber 21 is set to atmospheric pressure and the pressure of the upper chamber 20 is set to atmospheric pressure or less, thereby stopping the pressurization by the pressing member 22. As a result, a hydrostatic pressure is applied to the multilayer structure 16 under atmospheric pressure.

After the lamination step is finished, the multilayer structure 16 is carried out from the lamination apparatus and is then carried into a furnace used for the curing step. The curing step is a step of promoting a crosslinking reaction of the thermosetting resin forming each of the first encapsulant 14 and the second encapsulant 15 to increase the crosslinking density, and promoting a coupling reaction among the solar cells 11, the glass substrate 12, and the back sheet 13. The furnace is not particularly limited, as long as the multilayer structure 16 can be carried into the furnace. For example, a resistance furnace can be used.

An ambient temperature in the furnace is preferably in a range from 140°C to 170°C, and is more preferably in a range from 150°C to 160°C. The time for the curing step is generally longer than that for the lamination step, and is about five minutes to 60 minutes, or about 10 minutes to 45 minutes. After the curing step is finished, a trimming step of trimming the multilayer structure 16 and an attachment step of attaching a frame or a terminal box are performed, as needed, to thereby obtain the solar cell module 10.

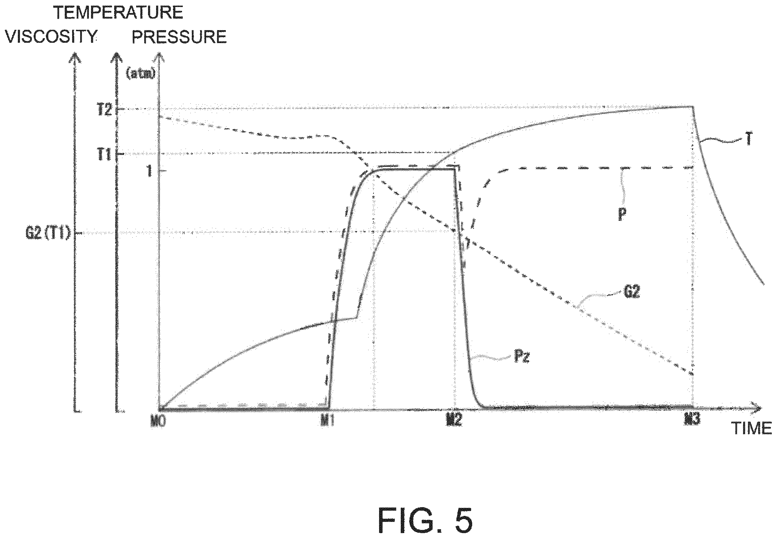

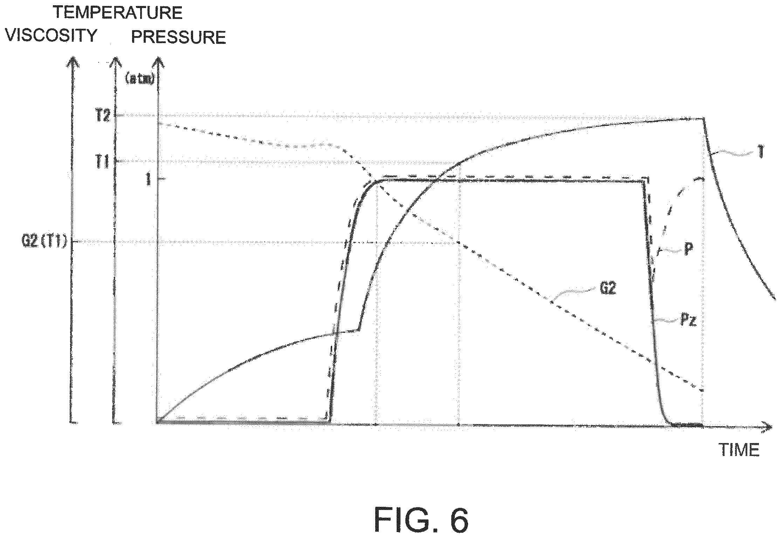

FIG. 5 is a graph illustrating a pressure P that acts on the multilayer structure 16 at each point in the lamination step, a temperature T of the multilayer structure 16, and the loss modulus G2 of the first encapsulant 14. A pressure Pz indicates a pressing force to be applied to the multilayer structure 16 by the pressing member 22. FIG. 6 illustrates a lamination step of a related art as a comparison example. The temperature T of the multilayer structure 16 is obtained by attaching thermocouples to inner surfaces of the glass substrate 12 and the back sheet 13, respectively, and averaging measured values of the thermocouples. When the pressurization by the pressing member 22 is started once (M1), the members of the multilayer structure 16 are brought into close contact with each other, and thus have substantially the same temperature. Unless otherwise noted herein, the temperature of the multilayer structure 16 indicates an average temperature.

As illustrated in FIG. 5, in the lamination step, the multilayer structure 16 is heated for a predetermined time (M0 to M1) while the upper chamber 20 and the lower chamber 21 are evacuated, and then the pressurization by the pressing member 22 is started (M1). The predetermined time (M0 to M1) is, for example, 10 seconds to 90 seconds. A pressing force Pz of the pressing member 22 is, for example, 1 atm at maximum. The pressing force Pz is, for example, 0.6 to 0.8 atm. The lamination apparatus may include a pressurization mechanism having a pressing force exceeding 1 atm.

In the lamination step, each member constituting the multilayer structure 16 is crimped by the pressing member 22. The multilayer structure 16 is evacuated in advance, so that almost no gas remains in gaps between the members. Accordingly, each encapsulant that is softened to some extent can be easily brought into contact with the solar cells 11, the glass substrate 12, and the back sheet 13 with no voids formed therein. Further, the multilayer structure 16 is strongly pressed against the heater 23 and the temperature T rises to a large extent. As the temperature of the multilayer structure 16 rises, the loss modulus G2 (viscosity) of the first encapsulant 14 decreases to a large extent (the same holds true for the loss modulus G2 of the second encapsulant 15).

In the lamination step, the pressurization by the pressing member 22 is stopped at a temperature T1 at which the first encapsulant 14 maintains a predetermined loss modulus G2 (T1) (M2). The pressurization by the pressing member 22 can be stopped by setting the pressure in the lower chamber 21 to atmospheric pressure and setting the pressure in the upper chamber 20 to atmospheric pressure or less. Consequently, it is possible to prevent the second encapsulant 15 from reaching the light receiving surface of each of the solar cells 11 at a high level. The phenomenon in which the second encapsulant 15 reaches the light receiving surface of each of the solar cells 11 is more likely to occur at an end of the solar cell module 10. However, the lamination step makes it possible to fully prevent the phenomenon that occurs at an end of the solar cell module 10.

After the pressurization by the pressing member 22 is stopped, the heating is preferably continued until the temperature T of the multilayer structure 16 reaches a higher one of the cross-linking start temperature of the first encapsulant 14 and the cross-linking start temperature of the second encapsulant 15. If the cross-linking start temperature of the first encapsulant 14 > the cross-linking start temperature of the second encapsulant 15 holds, after the pressurization by the pressing member 22 is stopped, the heating is continued until the temperature T of the multilayer structure 16 reaches at least a cross-linking start temperature T2 of the first encapsulant 14 (M3). The heating at M2 and M3 is carried out under atmospheric pressure. Accordingly, the multilayer structure 16 is pressurized at the hydrostatic pressure under atmospheric pressure, which contributes to the effect of softening each encapsulant along with a temperature rise. Even in a case where voids are present, the voids are filled and adhesion properties of each encapsulant with respect to the solar cells 11 and the like are further enhanced.

Although the pressurization by the pressing member 22 is essential for thermally compressing the multilayer structure 16, the pressing member 22, which is a flexible rubber-like member, releases rubber distortion energy such as a bending force caused immediately after the pressing is started, so that it is considered that an ununiform force acts on the multilayer structure 16 (see FIG. 3). As a result of studies, the present inventors have proved that the pressurization by the pressing member 22 has a large influence on the phenomenon in which the second encapsulant 15 reaches the light receiving surface of each of the solar cells 11.

In the lamination step illustrated in FIG. 5, the pressurization by the pressing member 22 is stopped based on the loss modulus G2 of the first encapsulant 14. After that, the heating is continued under atmospheric pressure. In this case, in a temperature range in which the loss modulus G2 is lower than the predetermined loss modulus G2 (T1), the multilayer structure 16 is more uniformly pressurized at the hydrostatic pressure under atmospheric pressure. Specifically, it is considered that the multilayer structure 16 does not receive any irregular force similar to the force received when the multilayer structure 16 is pressurized by the pressing member 22, and each encapsulant is not stirred, so that the phenomenon in which the second encapsulant 15 reaches the light receiving surface of each of the solar cells 11 is less likely to occur.

On the other hand, as illustrated in FIG. 6, if the pressurization by the pressing member 22 is continued in a temperature range in which the loss modulus G2 is lower than the predetermined loss modulus G2 (T1) without taking into consideration the loss modulus G2 of the first encapsulant 14, the phenomenon in which the second encapsulant 15 reaches the light receiving surface of each of the solar cells 11 is more likely to occur. According to the method of the related art, the time for pressurization by the pressing member 22 is generally long and the solar cell module is generally carried out of the lamination apparatus immediately after the pressurization by the pressing member 22 is finished.

The pressurization by the pressing member 22 is stopped by introducing the atmosphere into the lower chamber 21 and returning the air pressure in the lower chamber 21 to atmospheric pressure. In the present embodiment, the decompression of the upper chamber 20 is started first, and then the air pressure in the lower chamber 21 is returned to atmospheric pressure. Accordingly, the pressure P that acts on the multilayer structure 16 is temporarily decreased, but is then returned to atmospheric pressure immediately. After that, the heating of the multilayer structure 16 is continued under atmospheric pressure until the temperature T reaches at least the cross-linking start temperature T2 of the first encapsulant 14, and then the crosslinking reaction of the first encapsulant 14 is started. Starting the crosslinking reaction of the first encapsulant 14 prevents deviation, peeling, or the like from occurring in the members of the multilayer structure 16 due to an impact or the like when the multilayer structure 16 is carried out of the lamination apparatus and is supplied to the subsequent steps. Further, the reaction of the silane coupling agent is also promoted by continuing the heating. The pressure in the upper chamber 20 may be less than or equal to the pressure in the lower chamber 21, or may be equal to atmospheric pressure, like in the upper chamber 20 and the lower chamber 21.

Heating of the multilayer structure 16 under atmospheric pressure as described above can be performed in the curing step by carrying the multilayer structure 16 out of the lamination apparatus. However, in this case, the adhesion properties between the encapsulants and other members are insufficient in the lamination step, which increases the possibility that the above-described peeling or the like may occur when the multilayer structure 16 is carried in the curing step. If voids remain in the multilayer structure 16, gas enters the voids with time due to emission of gas from each material or entry of gas from the outside, which makes it difficult to remove the remaining voids. In other words, continuing the heating of the multilayer structure 16 under atmospheric pressure in the lamination apparatus greatly contributes to facilitating the conveyance and removing the remaining voids due to an improvement in adhesion properties between encapsulants and other members.

The loss modulus G2 (T1) of the first encapsulant 14, which is a threshold for stopping the pressurization by the pressing member 22, is preferably set to a value that is greater than or equal to 10³ Pa. For example, the loss modulus G2 (T1) is set in a range from 10³ Pa to 10⁶ Pa. If the loss modulus G2 (T1) (threshold) is less than 10³ Pa, the above-described phenomenon in which the second encapsulant 15 reaches the light receiving surface of each of the solar cells 11 is more likely to occur. On the other hand, if the loss modulus G2 (T1) exceeds 10⁶ Pa, it is assumed that the thermal compression for the multilayer structure 16 is insufficient and the adhesion properties between the encapsulants and the substrate deteriorate. The temperature T1 at which the first encapsulant 14 maintains the loss modulus of 10³ Pa is, for example, 115°C or less, or 110°C or less.

Further, in consideration of the loss modulus of the second encapsulant 15, the pressurization by the pressing member 22 may be stopped at a temperature at which the loss modulus of the second encapsulant 15 is maintained at 10⁴ Pa or more.

During the pressurization of the multilayer structure 16 by the pressing member 22, the viscosity of the second encapsulant 15 may be higher than the viscosity of the first encapsulant 14. In a case where POE is used as the first encapsulant 14 and EVA is used as the second encapsulant 15, the viscosity (loss modulus) during the pressurization by the pressing member 22, i.e., before hardening, generally satisfies "first encapsulant 14 < second encapsulant 15". In this case, the pressurization by the pressing member 22 is preferably stopped, in particular, based on the loss modulus of the first encapsulant 14.

The pressurization time (M1 to M2) for the multilayer structure 16 by the pressing member 22 is considerably reduced compared with that in the lamination step of the related art. The pressurization time (M1 to M2) is, for example, 90 seconds or less. For example, the pressurization time is preferably 30 seconds to 60 seconds. By controlling the time for pressurization by the pressing member 22 to be a short period of time, the temperature of each encapsulant can be maintained at a temperature at which the loss modulus is 10³ Pa or more, and the above-described phenomenon in which the second encapsulant 15 reaches the light receiving surface of each of the solar cells 11 can be prevented at a high level. In addition, the time for the lamination step can be reduced.

In the lamination step, the pressurization by the pressing member 22 may be stopped at a point when the temperature of the multilayer structure 16 reaches 80°C to 110°C, or 85°C to 105°C. As described above, the loss modulus of each encapsulant used for the solar cell module 10 is generally lower than 10³ Pa at around 110°C. Accordingly, the pressurization by the pressing member 22 is stopped at 110°C, which is set as a threshold, and the above-described phenomenon in which the second encapsulant 15 reaches the light receiving surface of each of the solar cells 11 can be prevented at a high level. On the other hand, if the threshold is less than 80°C, it is assumed that the thermal compression for the multilayer structure 16 is insufficient and the adhesion properties between the encapsulants and the substrate deteriorate. The threshold is preferably set within a range from 80°C to 110°C based on the loss modulus of each encapsulant.

As described above, according to the manufacturing method described above, it is possible to prevent the second encapsulant 15 from reaching the light receiving surface of each of the solar cells 11 at a high level. In particular, if the second encapsulant 15 includes a coloring material, the phenomenon in which the second encapsulant 15 reaches the light receiving surface of each of the solar cells 11 has a great influence on the power generation performance and design of the solar cell module 10. Therefore, the manufacturing method according to the present embodiment is preferably applied.

Further, according to the manufacturing method of the present disclosure, a satisfactory adhesion force of each of the encapsulants and the substrate can be obtained. A peeling strength evaluated in a peeling test conducted at 180° for the glass substrate 12 and the first encapsulant 14 after the lamination step reaches 10 N/cm, for example, at the highest achieved temperature of 135°C, and reaches 30 N/cm or more at the highest achieved temperature of 140°C. Accordingly, after the pressurization by the pressing member 22 is stopped, the multilayer structure 16 is left at rest in the lamination apparatus and is then heated until the temperature of the multilayer structure 16 reaches a temperature of 135°C or more under atmospheric pressure, so that the multilayer structure 16 can obtain an adhesion strength high enough for the multilayer structure 16 to be conveyed to the subsequent steps.

While the foregoing has described what are considered to be the best mode and/or other examples, it is understood that various modifications may be made therein and that the subject matter disclosed herein may be implemented in various forms and examples, and that they may be applied in numerous applications, only some of which have been described herein. It is intended by the following claims to claim any and all modifications and variations that fall within the true scope of the present disclosure.

## Claims

1. A manufacturing method of a solar cell module, comprising:
a lamination step of heating a multilayer structure while pressurizing the multilayer structure with a pressing member, the multilayer structure having a structure in which a solar cell, a first substrate that covers a light receiving surface of the solar cell, a second substrate that covers a rear surface of the solar cell, a first encapsulant filled in a space between the first substrate and the solar cell, and a second encapsulant filled in a space between the solar cell and the second substrate, are superimposed,
wherein in the lamination step, the pressurization by the pressing member is stopped at a temperature at which a loss modulus of the first encapsulant is maintained at 10³ Pa or more.

2. A manufacturing method of a solar cell module, comprising:
a lamination step of heating a multilayer structure while pressurizing the multilayer structure with a pressing member, the multilayer structure having a structure in which a solar cell, a first substrate that covers a light receiving surface of the solar cell, a second substrate that covers a rear surface of the solar cell, a first encapsulant filled in a space between the first substrate and the solar cell, and a second encapsulant filled in a space between the solar cell and the second substrate, are superimposed,
wherein in the lamination step, the pressurization by the pressing member is stopped at a point when a temperature of the multilayer structure reaches a temperature in a range from 80°C to 110°C.

3. The manufacturing method of the solar cell module according to claim 1 or 2,
wherein each of the first encapsulant and the second encapsulant includes a thermosetting resin, and
wherein in the lamination step, after the pressurization by the pressing member is stopped, the heating is continued until a temperature of the multilayer structure reaches a higher one of a cross-linking start temperature of the first encapsulant and a cross-linking start temperature of the second encapsulant.

4. The manufacturing method of the solar cell module according to claim 1 or 2,
wherein each of the first encapsulant and the second encapsulant includes a thermosetting resin, and
wherein in the lamination step, after the pressurization by the pressing member is stopped, the heating is continued until a temperature of the multilayer structure reaches 135°C or higher.

5. The manufacturing method of the solar cell module according to any one of claims 1 to 4, wherein during the pressurization of the multilayer structure by the pressing member, a viscosity of the second encapsulant is higher than a viscosity of the first encapsulant.

6. The manufacturing method of the solar cell module according to any one of claims 1 to 5, wherein a time for the pressurization of the multilayer structure by the pressing member is 90 seconds or less.

7. The manufacturing method of the solar cell module according to any one of claims 1 to 6, further comprising a curing step of performing a heat treatment on the multilayer structure thermally compressed in the lamination step.

8. The manufacturing method of the solar cell module according to any one of claims 1 to 7, wherein the second encapsulant includes a coloring material.
